(19) Europäisches Patentamt
European Patent Office
Office européen des brevets

(11) EP 2 398 137 A2

(12) **EUROPÄISCHE PATENTANMELDUNG**

(43) Veröffentlichungstag:
   **21.12.2011 Patentblatt 2011/51**

(51) Int Cl.:
   *H02M 7/48* (2007.01)

(21) Anmeldenummer: **11004504.4**

(22) Anmeldetag: **01.06.2011**

(84) Benannte Vertragsstaaten:
   **AL AT BE BG CH CY CZ DE DK EE ES FI FR GB GR HR HU IE IS IT LI LT LU LV MC MK MT NL NO PL PT RO RS SE SI SK SM TR**
   Benannte Erstreckungsstaaten:
   **BA ME**

(30) Priorität: **17.06.2010 DE 102010024128**

(71) Anmelder: **Diehl AKO Stiftung & Co. KG**
   **88239 Wangen im Allgäu (DE)**

(72) Erfinder:
• **Kaps, Werner**
   **88171 Weiler-Simmerberg (DE)**
• **Simon, Helmut**
   **88260 Argenbühl (DE)**
• **Landerer, Andreas**
   **87527 Ofterschwang (DE)**

(74) Vertreter: **Diehl Patentabteilung**
   **c/o Diehl Stiftung & Co. KG**
   **Stephanstraße 49**
   **D-90478 Nürnberg (DE)**

(54) **Wechselspannungssteller**

(57)   Ein Wechselspannungssteller weist zwei Transistoren, (4, 5) auf, die zwischen zwei Wechselspannungsanschlüssen (7, 8) in Reihe zu einer Last (6) setzbar sind, wobei die zwei Transistoren (4, 5) derart in Reihe geschaltet sind, dass ihre jeweiligen Source-Anschlüsse miteinander verbunden sind. Er enthält ferner einen Signalgeber (1) zum Erzeugen eines Schaltsignals zum Ansteuern der beiden Transistoren (4, 5), einen dem Signalgeber (1) nachgeschalteten Zwischenspeicher (2), welcher von dem Signalgeber (1) gesetzt wird, um die beiden Transistoren (4, 5) anzusteuern; eine Ansteuer- oder Treiberschaltung (3), welche dem Zwischenspeicher (2) nachgeschaltet ist, zum Ansteuern der beiden Transistoren (4,5) entsprechend dem gesetzten Zustand des Zwischenspeichers (2); und eine Strombegrenzungsschaltung (9-11) zum Begrenzen oder Abschalten des Stroms durch die zwei Transistoren (4, 5) im Fall eines zu großen Stroms durch die Last (6).

Fig. 2

EP 2 398 137 A2

**Beschreibung**

Die vorliegende Erfindung betrifft einen Wechselspannungssteller, insbesondere einen Wechselspannungssteller mit einer Wechselspannungsschaltstufe, die zwei in Reihe geschaltete Transistoren enthält.

Derartige Wechselspannungsstelle werden beispielsweise in Energiemanagement- bzw. Hausautomatisierungssystemen benötigt, welche eine Anzahl elektrischer oder elektronischer Geräte oder Komponenten (z.B. Leuchten, Jalousien, etc.) umfassen, deren Betrieb gesteuert werden soll.

Wechselspannungssteller, insbesondere Wechselspannungssteller für Leuchtmittel, wurden früher typischerweise mit Triacs aufgebaut. Aufgrund der Eigenschaft des Triacs, nach einmaliger Zündung bis zur Erreichung des Stromnulldurchganges eingeschaltet zu bleiben, war unter vertretbarem Aufwand lediglich die so genannte Phasenanschnittssteuerung möglich. Nachteil der Phasenanschnittssteuerung beim Einsatz zur Leuchtensteuerung ist ein hörbares Summen des Lampenglühfadens aufgrund des steilen Stromanstieges. Mit dem steilen Stromanstieg ist ebenfalls eine erhöhte Aussendung von Störsignalen verbunden, welche sich auch bei anderen resistiven und kapazitiven Lasten negativ auswirkt. Die Entnahme eines nichtsinusförmigen Stromes bewirkt zudem Oberwellen, deren Werte durch einschlägige Normen in Stromnetzen limitiert sind.

Um einen Phasenabschnitt zu realisieren, welcher vorteilhaft die Nachteile des Phasenanschnitts vermeidet, da der Strom im Nulldurchgang zugeschaltet wird und mit der Sinuswelle der Netzspannung vergleichbar langsam ansteigt, gibt es die Möglichkeit, den Verbraucher in Serie zu den Wechselspannungsanschlüssen eines Brückengleichrichters zu schalten und an den Gleichspannungsanschlüssen des Brückengleichrichters einen Schalttransistor zu betreiben. Bei eingeschaltetem Transistor auf der Gleichspannungsseite kommt auf der Wechselspannungsseite ein Strom ungeachtet der gerade anstehenden Polarität des Wechselstromnetzes zum fließen. Nachteilig ist dabei, dass bei eingeschaltetem Verbraucher sowohl Durchlassverlustleistung als auch Schaltverlustleistung an den beiden leitenden Dioden des Brückengleichrichters sowie zusätzlich am Schalttransistor entstehen und damit die maximal in einem kleinen Volumen unterbringbare Schaltleistung begrenzt ist.

Seit einigen Jahren gibt es aufgrund des Fortschrittes in der Entwicklung von Leistungs-MOSFETs am Markt Wechselspannungsschaltstufen, bei denen zwei MOSFETs so in Serie geschaltet werden, dass ihre Source-Anschlüsse miteinander verbunden sind und die Last dazu in Serie geschaltet wird. Wenn als Bezugspunkt einer Ansteuerschaltung diese Source-Verbindung benutzt wird, so können beide MOSFETs mit einem gegenüber diesem Bezugspunkt positiven Signal eingeschaltet werden. Vorteilhaft bei einer solchen MOSFET-Schaltstufe ist, dass nur Verlustleistung an einer Diode, der parasitären Diode des Transistors, entsteht. Bei sehr niedrigem On-Widerstand des MOSFETs ist dessen eigene Verlustleistung gering gegenüber dem der Diodenstrecke(n); und gegenüber dem oben beschriebenen Prinzip mittels Gleichrichter ist die Gesamtverlustleistung bestenfalls fast halbiert. Soll ein Verbraucher nur statisch ein- oder ausgeschaltet werden, genügt es also, wenn ein Signalgeber über einen Treiberbaustein beide MOSFET-Gates parallel ansteuert.

Es ist die Aufgabe der Erfindung, einen verbesserten Wechselspannungssteller mit einer Wechselspannungsschaltstufe mit zwei in Reihe geschalteten Transistoren zu schaffen, der einen kompakten Aufbau besitzt und eine effektive Strombegrenzung ermöglicht.

Diese Aufgabe wird gelöst durch einen Wechselspannungssteller mit den Merkmalen des Anspruchs 1. Vorteilhafte Ausgestaltungen und Weiterbildungen der Erfindung sind Gegenstand der abhängigen Ansprüche.

Der Wechselspannungssteller weist zwei Transistoren, die zwischen zwei Wechselspannungsanschlüssen in Reihe zu einer Last setzbar sind, wobei die zwei Transistoren derart in Reihe geschaltet sind, dass ihre jeweiligen Source-Anschlüsse miteinander verbunden sind; und einen Signalgeber zum Erzeugen eines Schaltsignals zum Ansteuern der beiden Transistoren auf. Dieser Wechselspannungssteller weist ferner einen dem Signalgeber nachgeschalteten Zwischenspeicher, welcher von dem Signalgeber gesetzt wird, um die beiden Transistoren anzusteuern, und eine Ansteuer- oder Treiberschaltung, welche dem Zwischenspeicher nachgeschaltet ist, zum Ansteuern der beiden Transistoren entsprechend dem gesetzten Zustand des Zwischenspeichers auf.

Die Verwendung des Zwischenspeichers nach dem Signalgeber ermöglicht eine sehr schnelle und sehr einfach aufgebaute Strombegrenzung der beiden Transistoren der Wechselspannungsschaltstufe. Ein kleines Bauvolumen für den Wechselspannungssteller ist von Vorteil bei der Installation in Energiemanagement- bzw. Hausautomatisierungssystemen und dort insbesondere beim Einbau in Unterputzdosen.

Beim Setzen des Zwischenspeichers durch den Impulsgeber wird die Wechselspannungsschaltstufe über die zusätzliche Ansteuerschaltung eingeschaltet, beim Zurücksetzen des Zwischenspeichers durch den Impulsgeber wird die Wechselspannungsschaltstufe ausgeschaltet. Der Zwischenspeicher ermöglicht auf diese Weise zudem eine Entlastung des Signalgebers.

Der Signalgeber enthält beispielsweise einen Mikrocontroller, kann aber auch ein einfacher Taster sein. Der Zwischenspeicher enthält beispielsweise eine Flip-Flop-Schaltung.

Für die beiden Transistoren der Wechselspannungsschaltstufe werden vorzugsweise MOSFETs oder Leistungs-MOSFETs eingesetzt. Das erfindungsgemäße Schaltungsprinzip funktioniert aber grundsätzlich auch mit IGBTs und bipolaren Transistoren, denen eine Diode antiparallel zur Flussrichtung von Kollektor zu Emitter geschaltet ist.

Der Zwischenspeicher kann mit dem Signalgeber wahlweise über eine Signalleitung, welche die Schaltsignale zum Einschalten und Ausschalten überträgt, oder über zwei Signalleitungen, welche die Schaltsignale zum Einschalten bzw. zum Ausschalten übertragen, verbunden sein.

Gemäß der Erfindung ist ferner eine Strombegrenzungsschaltung zum Begrenzen oder Abschalten des Stroms durch die zwei Transistoren im Fall eines zu großen Stroms durch die Last vorgesehen. Aufgrund des vorhandenen Zwischenspeichers kann diese Strombegrenzungsschaltung sehr einfach und kompakt aufgebaut werden.

Vorzugsweise weist die Strombegrenzungsschaltung ein erstes und ein zweites Schaltelement (z.B. Transistoren oder Komparatoren) sowie wenigstens einen in Reihe zu den zwei Transistoren der Wechselspannungsschaltstufe geschalteten Widerstand auf. Ein Spannungsabfall an dem wenigstens einen Widerstand in der einen Stromrichtung durch den Verbraucher schaltet das erste Schaltelement durch und ein Spannungsabfall an dem wenigstens einen Widerstand in der anderen Stromrichtung durch den Verbraucher schaltet das zweite Schaltelement durch. Bei einem solchen Durchschalten steuert das erste bzw. zweite Schaltelement den Signalgeber und/oder den Zwischenspeicher derart an, dass die beiden Transistoren der Wechselspannungsschaltstufe ausgeschaltet werden.

In einer Ausführungsform enthält diese Strombegrenzungsschaltung einen ersten Widerstand in Serie zum ersten Transistor und einen zweiten Widerstand in Serie zum zweiten Transistor. Bei positiver Stromrichtung durch die Last steuert der Spannungsabfall über dem ersten Serienwiderstand das erste Schaltelement durch und bei negativer Stromrichtung durch die Last steuert der Spannungsabfall über dem zweiten Serienwiderstand das zweite Schaltelement durch.

In einer anderen Ausführungsform enthält diese Strombegrenzungsschaltung nur einen Widerstand in Serie zum ersten und zum zweiten Transistor der Wechselspannungsschaltstufe. Bei positiver Stromrichtung durch die Last steuert der Spannungsabfall über diesem Serienwiderstand das erste Schaltelement durch und bei negativer Stromrichtung durch die Last steuert der Spannungsabfall über diesem Serienwiderstand das zweite Schaltelement durch.

In beiden Ausführungsformen bewirkt das Durchschalten eines der beiden Schaltelemente der Strombegrenzungsschaltung ein Zurücksetzen des Zwischenspeichers, um so die Wechselspannungsschaltstufe auszuschalten, und/oder ein Triggern des Signalgebers, um ein erneutes Setzen des Zwischenspeichers zu verhindern.

In einer weiteren Ausgestaltung der Erfindung ist ein Ausgang des Zwischenspeichers mit einem Eingang des Signalgebers verbunden. Auf diese Weise kann der Signalgeber jederzeit den aktuellen Schaltzustand des Zwischenspeichers und damit auch der Transistoren der Wechselspannungsschaltstufe erfassen.

Zum Beispiel kann der Signalgeber auf diese Weise erkennen, wenn sich der Zustand des Zwischenspeichers ändert. In diesem Fall kann der Signalgeber beispielsweise weiter erkennen, dass diese Änderung erfolgt ist, ohne dass der Signalgeber selbst ein entsprechendes Rücksetzsignal gesendet hat. Daraus kann der Signalgeber dann beispielsweise bei Vorhandensein der oben beschriebenen Strombegrenzungsschaltung schließen, dass ein Überstrom die Ursache für das Rücksetzen des Zwischenspeichers gewesen sein muss.

In einer noch weiteren Ausgestaltung der Erfindung ist der Signalgeber zum Erfassen eines Spannungsabfalls über der Last ausgebildet. Zu diesem Zweck ist zum Beispiel ein erster Eingang des Signalgebers (unmittelbar oder über z.B. eine Konditionierungsschaltung) mit einem ersten Anschluss der Last verbunden und ist ein zweiter Eingang des Signalgebers (unmittelbar oder über z.B. eine Konditionierungsschaltung) mit einem zweiten Anschluss der Last verbunden, um die Spannungsverläufe an den beiden Anschlüssen der Last zu erfassen. Aus den beiden so erfassten Spannungsverläufen kann in dem Signalgeber dann der unverfälschte Lastspannungsverlauf als Differenz der beiden Einzelspannungen berechnet werden.

In einer noch weiteren Ausgestaltung der Erfindung ist der Signalgeber zum Erfassen eines Stromverlaufs durch die Last ausgebildet.

Können Spannungsverlauf und Stromverlauf über bzw. durch die Last erfasst werden, so kann daraus in vorteilhafter Weise die von der Last aufgenommene Leistung bestimmt werden.

Wird der Stromverlauf durch die Last von dem Signalgeber erfasst, so kann der Signalgeber zum Beispiel bei Überschreitung eines vorgegebenen Schwellwertes (z.B. für den zeitlichen Mittelwert des gemessenen Stromes) die Ansteuerleistung reduzieren oder ganz abschalten. Im Fall einer nichtlinearen Last (z.B. Glühfadenlampe oder Kapazität) kann der Signalgeber beispielsweise den Ansteuerprozentsatz beim Einschaltvorgang schrittweise bis zum gewünschten Endwert erhöhen.

Zum Zwecke der Strommessung ist beispielsweise ein Kondensator vorgesehen, welcher einen dem Wechselstromanteil über den wenigstens einen Widerstand proportionalen Wechselspannungsabfall auskoppelt und einem Eingang des Signalgebers (unmittelbar oder über eine Auswerteschaltung) zuführt. Der Kondensator koppelt den dem Wechselstromanteil über den wenigstens einen Widerstand proportionalen Wechselspannungsabfall vorzugsweise auf einen Spannungsteiler aus.

Der Signalgeber kann zudem derart ausgebildet sein, um ein Verhältnis dieses Spannungsteilers einzustellen. Dies kann beispielsweise dadurch erfolgen, dass durch den Signalgeber dem Spannungsteiler wenigstens eine Impedanz parallel geschaltet wird.

In einer Ausgestaltung der Erfindung ist der Signalgeber ferner ausgebildet, um einen Referenzstrom bei ausgeschalteter Last oder bei bekanntem Strom zu erfassen und diesen Referenzstrom bei der Erfassung des Stromverlaufs durch die Last zu berücksichtigen.

Eine Toleranz des Spannungsteilers kann beispielsweise eliminiert werden, indem eine Software des Signalgebers bei (durch die beiden Transistoren der Wechselspannungsschaltstufe) abgeschalteter Last einen entsprechenden Stromreferenzwert durch die Last erfasst. Bei späteren Strommessungen können dann korrekte Stromwerte ermittelt werden, indem die gemessenen Werte mit dem Stromreferenzwert verrechnet werden.

Eine Toleranz des Serienwiderstandes zur Strommessung kann beispielsweise eliminiert werden, indem bei bekanntem Strom durch die Last eine Referenzmessung durchgeführt wird und ein Korrekturwert, der die Abweichung zwischen dem gemessenen und dem tatsächlichen Stromwert charakterisiert, in einem Speicher abgelegt wird. Bei späteren Strommessungen können dann korrekte Stromwerte ermittelt werden, indem die gemessenen Werte mit dem abgespeicherten Korrekturwert verrechnet werden.

In einer Ausgestaltung der Erfindung ist der Signalgeber zudem, derart ausgebildet, dass er beim Einschalten einer nichtlinearen Last (z.B. Glühfadenlampe oder Kapazität) ein Ansprechen einer Strombegrenzung für eine vorbestimmte Zeitdauer ignoriert.

In einer noch weiteren Ausgestaltung der Erfindung ist der Signalgeber mit einem (internen oder externen) Speicher versehen, in welchem ein ein- oder mehrmals ermitteltes Einschaltverhalten der Last abgelegt werden kann. Insbesondere im Fall nichtlinearer Lasten kann dann bei nachfolgenden Einschaltvorgängen der Ansteuerprozentsatz durch den Signalgeber schrittweise bis zu dem gewünschten Endwert erhöht werden. Dabei werden die Erhöhungsschritte vorzugsweise im Vergleich zum betrachteten Einschaltverhalten so gewählt, dass die Strombegrenzung gerade noch nicht anspricht.

Eine mögliche beispielhafte Anwendung des erfindungsgemäßen Wechselspannungsstellers ist ein Wechselstromdimmer zum Steuern der Helligkeit einer Glühlampe.

Obige sowie weitere Merkmale, Vorteile und Anwendungsmöglichkeiten der Erfindung werden aus der nachfolgenden Beschreibung bevorzugter, nichteinschränkender Ausführungsbeispiele unter Bezugnahme auf die beiliegenden Zeichnungen besser verständlich. Darin zeigen:

Fig.1 1    ein vereinfachtes Blockschaltbild der Grundform eines Wechselspannungsstellers gemäß der Erfindung;

Fig. 2    ein vereinfachtes Blockschaltbild eines Wechselspannungsstellers gemäß einem ersten Ausführungsbeispiel der Erfindung;

Fig.3    ein vereinfachtes Blockschaltbild eines Wechselspannungsstellers gemäß einem zweiten Ausführungsbeispiel der Erfindung;

Fig.4    ein vereinfachtes Blockschaltbild eines Wechselspannungsstellers gemäß einem dritten Ausführungsbeispiel der Erfindung;

Fig.5    ein vereinfachtes Blockschaltbild eines Wechselspannungsstellers gemäß einem vierten Ausführungsbeispiel der Erfindung; und

Fig. 6    ein vereinfachtes Blockschaltbild eines Wechselspannungsstellers gemäß einem fünften Ausführungsbeispiel der Erfindung.

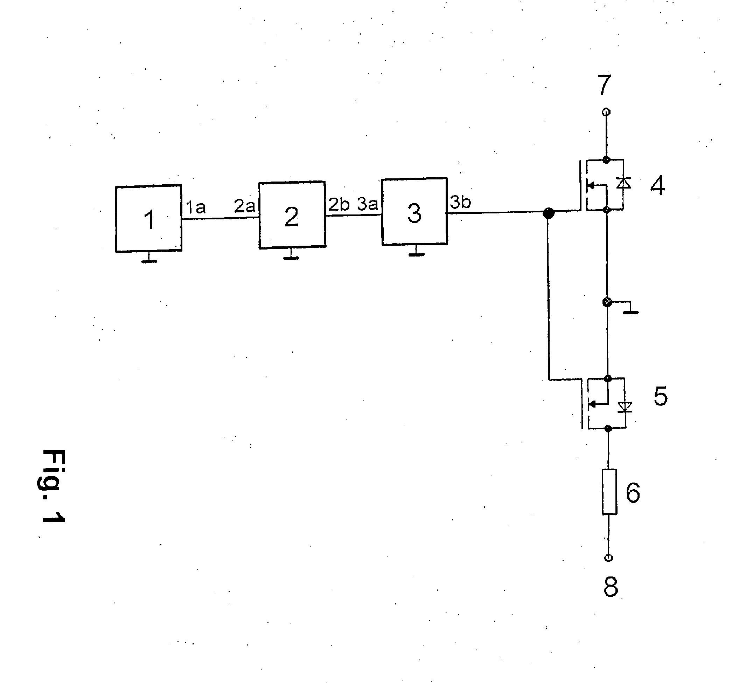

Fig. 1 zeigt die Grundform eines erfindungsgemäßen Wechselspannungsstellers.

Der Wechselspannungssteller von Fig. 1 enthält einen Signalgeber 1, der vorzugsweise einen Mikrocontroller und einen Speicher enthält. Ein Ausgang 1a dieses Signalgebers 1 ist mit einem Eingang 2a eines Zwischenspeichers 2 verbunden. Über diese Signalleitung 1a-2a setzt der Signalgeber den Zwischenspeicher 2 in den Zustand "Ein" oder den Zustand "Aus".

Ein Ausgang 2b des Zwischenspeichers 2 ist mit einem Eingang 3a einer Ansteuer- bzw. Treiberschaltung 3 verbunden. Über den Ausgang 3b steuert diese Ansteuerschaltung dann die Wechselspannungsschaltstufe entsprechend dem gesetzten Zustand des Zwischenspeichers 2.

Die Wechselspannungsschaltstufe enthält zwei Transistoren (vorzugsweise MOSFETs bzw. Leistungs-MOSFETs) 4 und 5. Diese Transistoren 4 und 5 sind derart in Reihe geschaltet, dass ihre jeweiligen Source-Anschlüsse miteinander verbunden sind. Außerdem ist die Last bzw. der Verbraucher 6 in Reihe zu dieser Reihenschaltung der beiden Transistoren 4, 5 geschaltet.

An den beiden Wechselspannungsanschlüssen 7 und 8 liegt die wechselstromförmige Netzspannung an. Wenn als Bezugspunkt der Ansteuerschaltung 3 die Verbindung der beiden Source-Anschlüsse verwendet wird, so können beide MOSFETs mit einem gegenüber diesem Bezugspunkt positiven Signal eingeschaltet werden. Wenn bei positiver Halbwelle der erste Anschluss 7 in der Spannung positiv gegenüber dem zweiten Anschluss 8 ist, fließt bei eingeschaltetem ersten Transistor 4 ein Strom vom ersten Wechselspannungsanschluss 7 über den ersten Transistor 4 und die parasitäre Diode des zweiten Transistors 5 durch die Last 6 zum zweiten Wechselspannungsanschluss 8. Umgekehrt fließt in der negativen Halbwelle ein Strom von dem zweiten Wechselspannungsanschluss 8 durch die Last 6 über den angesteuerten zweiten Transistor 5 und die parasitäre Diode des ersten Transistors 4 zum ersten Wechselspannungsanschluss 7.

Vorteilhaft bei einer solchen Wechselspannungsschaltstufe mit MOSFETs ist, dass nur Verlustleistung an einer Diode, der parasitären Diode des Transistors, entsteht. Bei sehr niedrigem On-Widerstand des MOSFETs ist dessen eigene Verlustleistung gering gegenüber dem der Diodenstrecke(n).

Soll eine Last 6 nur statisch ein- oder ausgeschaltet werden, genügt es also, wenn ein Signalgeber 1 über den Treiberbaustein 3 beide MOSFET-Gates parallel ansteuert. Wenn erfindungsgemäß ein Zwischenspeicher 2 zwischen den Signalgeber 1 und die Ansteuerschaltung 3 geschaltet ist, entlastet dieser zeitlich den Signalgeber 1.

Um einen Phasenabschnitt zu steuern, muss zudem ein Rechtecksignal im Signalgeber 1 oder einem anderen Schaltungsteil erzeugt werden, welches mit dem Nulldurchgang der Wechselspannung synchron einschaltet und nach einer Zeit vor dem nachfolgenden Nulldurchgang wieder ausschaltet. Grundsätzlich kann auch ein Signal beliebiger Frequenz zur Leistungssteuerung dienen, welches nicht mit der Wechselspannung synchronisiert ist, z.B. ein pulsweitenmoduliertes Signal. Dann sind allerdings die entstehenden Verlustleistungen und Störungen in der Schaltungsauslegung zu berücksichtigen. Die nachfolgenden Ausführungen beziehen sich ausdrücklich auf alle möglichen Signalformen des Ansteuersignals.

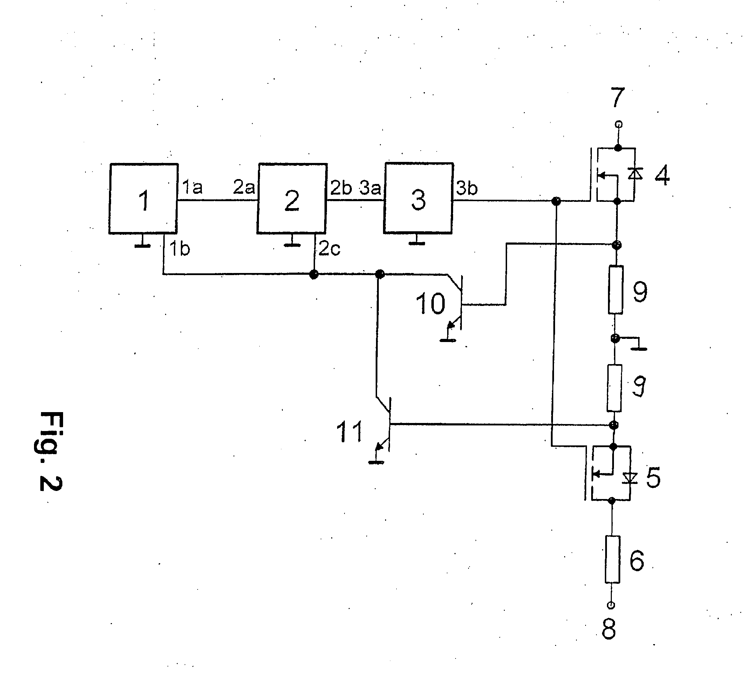

Bezug nehmend auf Fig. 2 wird nun ein erstes Ausführungsbeispiel eines Wechselspannungsstellers näher beschrieben. Gleiche bzw. entsprechende Komponenten sind dabei mit den gleichen Bezugsziffern wie in Fig. 1 gekennzeichnet.

Ein großes Problem für Halbleiterschalter stellen unzulässig hohe Ströme oder Stromspitzen dar, wie sie beispielsweise bei einem Kurzschluss des Verbrauchers 6 auftreten können. Solche Kurzschlüsse treten beispielsweise häufig kurzzeitig auf, wenn der Glühfaden einer Lampe durchbrennt, und können zur Zerstörung der Transistoren 4, 5 der Wechselspannungsschaltstufe führen.

Da die Abschaltung der Wechselspannungsschaltstufe möglichst schnell erfolgen muss, um dem steilen Stromanstieg im Kurzschlussfall entgegenzuwirken, empfiehlt sich eine Koppelung durch Hardware. Eine Abschaltung aufgrund einer Überstromauswertung durch Software ist im Normalfall zu langsam.

Zur Strombegrenzung kann der Spannungsabfall an zwei Widerständen 9 ausgenutzt werden, die in Reihe zwischen die beiden Source-Anschlüsse der Transistoren 4, 5 geschaltet sind. Die beiden Serienwiderstände 9 sind jeweils mit einem Schaltelement (z.B. Transistor oder Komparator) 10, 11 gekoppelt, um das Einschaltpotenzial des leitenden Transistors 4, 5 direkt oder über die Ansteuerschaltung 3 oder über den Zustandsspeicher 2 oder über den Signalgeber 1 zurückzunehmen. Dadurch wird der Strom abgeschaltet oder zumindest begrenzt. Wie in Fig. 2 dargestellt, sind die beiden Schaltelemente 10, 11 der Strombegrenzungsschaltung parallel geschaltet. Die Widerstände 9 sind dabei so zu bemessen, dass sie beim Nennstrom die Ansteuerung des Transistors 4, 5 nicht durch unzulässig hohe Anhebung des Source- (oder Emitter-) Potenzials behindern.

Bei positiver Stromrichtung durch die Last 6 steuert der Spannungsabfall über dem ersten Serienwiderstand 9 das erste Schaltelement 10 durch, während bei negativer Stromrichtung durch die Last 6 der Spannungsabfall über dem zweiten Serienwiderstand 9 das zweite Schaltelement 11 durchsteuert. Dieses Durchschalten eines der beiden Schaltelemente 10, 11 bewirkt ein Zurücksetzen des Zwischenspeichers 2, um so die Wechselspannungsschaltstufe 4, 5 auszuschalten, und/oder ein Triggern des Signalgebers 1, um ein erneutes Setzen des Zwischenspeichers 2 zu verhindern.

Die übrigen Merkmale des Wechselspannungsstellers von Fig. 2 entsprechen jenen von Fig. 1.

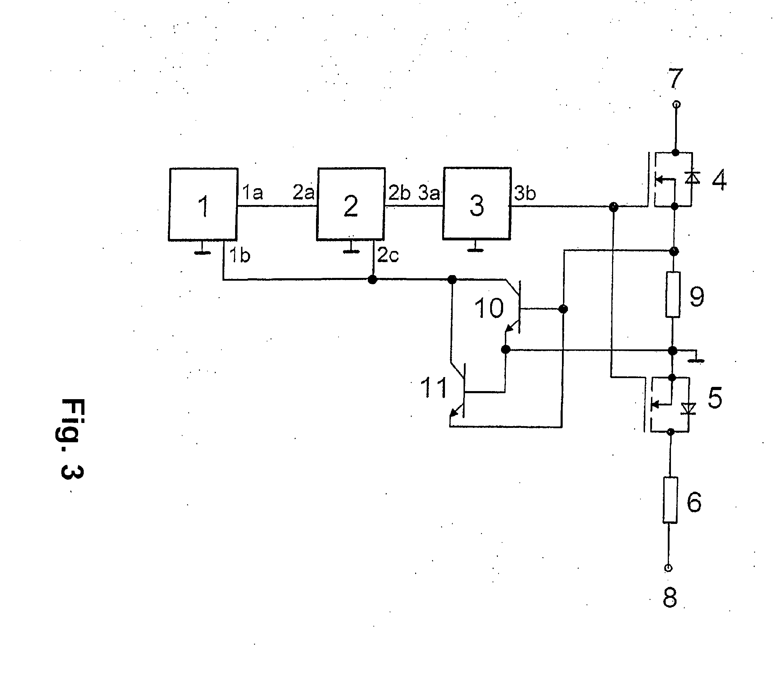

Bezug nehmend auf Fig. 3 wird nun ein zweites Ausführungsbeispiel eines Wechselspannungsstellers näher beschrieben. Gleiche bzw. entsprechende Komponenten sind dabei mit den gleichen Bezugsziffern wie oben gekennzeichnet.

Nachteilig bei der in Fig. 2 veranschaulichten Strombegrenzungsschaltung ist, dass zwei Leistungswiderstände 9 eingesetzt werden. Auch wenn sie wegen der Aufteilung der Verlustleistung jeweils nur den halben Leistungswert aufweisen müssen, benötigen sie in einem Layout deutlich mehr Platz, der möglicherweise überhaupt nicht zur Verfügung steht, was damit den Aufbau der Schaltung unmöglich macht. Einerseits sind zwei Bauteile größer als ein einziges, andererseits ist um die dann vier Anschlüsse der Bauteile herum auf der Leiterplatte ein Isolationsabstand einzuhalten, welcher seinerseits je nach Applikation einen nicht zu vernachlässigenden Platz benötigt. Zudem sind zwei gleichwertige Bauteile halber Leistung in der Regel teurer als ein einziges Bauteil, und es kommt eine Verdoppelung der Bestückungskosten hinzu.

In Fig. 3 wird daher ein Wechselspannungssteller mit einer Strombegrenzungsschaltung 9-11 vorgeschlagen, die mit nur einem Serienwiderstand 9 für die Strommessung auskommt. Dieser Serienwiderstand 9 ist in Reihe zwischen die Source-Anschlüsse der beiden Transistoren 4, 5 der Wechselspannungsschaltstufe geschaltet und mit den beiden parallel geschalteten Schaltelementen 9 und 10 gekoppelt.

Bei einem Stromfluss in der einen Netzhalbwelle von dem ersten Wechselspannungsanschluss 7 zum zweiten Wechselspannungsanschluss 8 entsteht an dem Widerstand 9 ein Spannungsabfall, welcher das erste Schaltelement 10 ansteuert. Ein umgekehrter Stromfluss von dem zweiten zum ersten Wechselspannungsanschluss 8 nach 7 in der negativen Netzhalbwelle erzeugt an dem Widerstand 9 einen Spannungsabfall in ebenfalls umgekehrter Richtung, welcher das zweite Schaltelement 11 ansteuert.

Dabei ist das Potenzial am Emitter des zweiten Schaltelements 11 negativ gegenüber dem Bezugspotenzial. Bei vollständiger Durchsteuerung des zweiten Schaltelements 11 könnte daher ein angeschlossenes Logikgatter beschädigt werden. Ein solches Gatter kommt zum Beispiel als Zwischenspeicher 2 oder Signalgeber 1 zum Einsatz. Da jedoch der Transistor 11 nicht unendlich schnell durchsteuern kann, wird zunächst einmal die Threshold-Spannung des Gatters an dessen Eingang 2c unterschritten und es schaltet seinen Ausgang und damit den gerade durchgeschalteten Leistungs-MOSFET 4 bzw. 5 bereits aus, bevor eine negative Spannung am Eingang 2c des Zwischenspeichers 2 oder am Eingang 1 b des Signalgebers 1 b auftreten kann.

Anstelle der in Fig. 3 gezeigten bipolaren Transistoren können für die Schaltelemente 10, 11 der Strombegrenzungsschaltung auch andere Schaltelemente wie MOSFETs oder Komparatoren eingesetzt werden.

Bei einem Wechselspannungssteller ist es wichtig, dass die Transistoren 4, 5 bei einem Kurzschluss vollständig ausgeschaltet werden und auch ausgeschaltet bleiben. Deshalb ist der dem Signalgeber 1 nachgeschaltete Zwischenspeicher 2 von besonderem Vorteil. Neben der eingangs beschriebenen Funktion, den Schaltzustand des Signalgebers 1 zwischenzuspeichern, erhält er in diesem Ausführungsbeispiel als weitere wichtige Funktion die Aufgabe, im Falle eines Überstromes den ausgeschalteten Zustand der Wechselspannungsschaltstufe bis zum nächsten Einschalten durch den Signalgeber 1 aufrecht zu erhalten.

Als Zwischenspeicher 2 bieten sich Flip-Flop-Schaltungen in verschiedenen Ausführungsformen an. Bei einem einfachen Set-Reset-Flipflop würde beispielsweise der Signalgeber 1 über zwei Leitungen (hier nicht dargestellt) abwechselnd ein Setz- und ein Rücksetz-Signal erzeugen. Bei einem Überstrom würde das dem Rücksetzeingang zugeführte Ausgangssignal des ersten oder zweiten Schaltelements 10, 11 der Strombegrenzungsschaltung eine sofortige Rücksetzung bewirken. Bei einem D-Flipflop oder JK-Flipflop ist alternativ nur ein einziger Eingang 2a des Zwischenspeichers 2 zur Steuerung durch den Signalgeber 1 erforderlich. Hierdurch kann vorteilhaft am Signalgeber 1 ein Ausgang eingespart werden. Die Rücksetzung erfolgt dann je nach Schaltungsauslegung durch einen Reset-, einen Preset oder einen Clear-Eingang des Flipflops.

Ist der Transistor 4, 5 durch die beschriebene Strombegrenzungsschaltung einmal ausgeschaltet, also der Zwischenspeicher 2 zurückgesetzt, wird er mit dem nächsten Setzsignal des Signalgebers 1 wieder eingeschaltet. Dies kann bei sehr schnell schaltender Signalkette hinreichend sein, den Transistor 4, 5 und den Rest der Schaltung vor Überlastung zu schützen. Falls nicht, ist es wünschenswert, den Signalgeber 1 daran zu hindern, die Last erneut einzuschalten.

Hierzu kann, wie in Fig. 3 dargestellt, in vorteilhafter Weise das gleiche Signal, welches von dem ersten oder dem zweiten Schaltelement 10, 11 ausgehend den Zwischenspeicher 2 zurücksetzt, dem Signalgeber 1 über einen weiteren Eingang 1b signalisieren, dass ein Überstrom vorliegt. Der Signalgeber 1 kann darauf in geeigneter Weise reagieren. Zum Beispiel kann er ein erneutes Ansteuersignal für eine bestimmte Zeit unterbleiben lassen. Dies ist leicht mit konventionellen Zeitgliedern wie z.B. Monovibratoren erreichbar. Falls ein Mikrocontroller als Signalgeber 1 zum Einsatz kommt, sind jedoch auch wesentlich intelligentere Algorithmen möglich. Es ist dabei allerdings zu beachten, dass das Signal nur sehr kurzzeitig zur Verfügung steht und daher einen speziellen z.B. flankengetriggerten Eingang 1b benötigt.

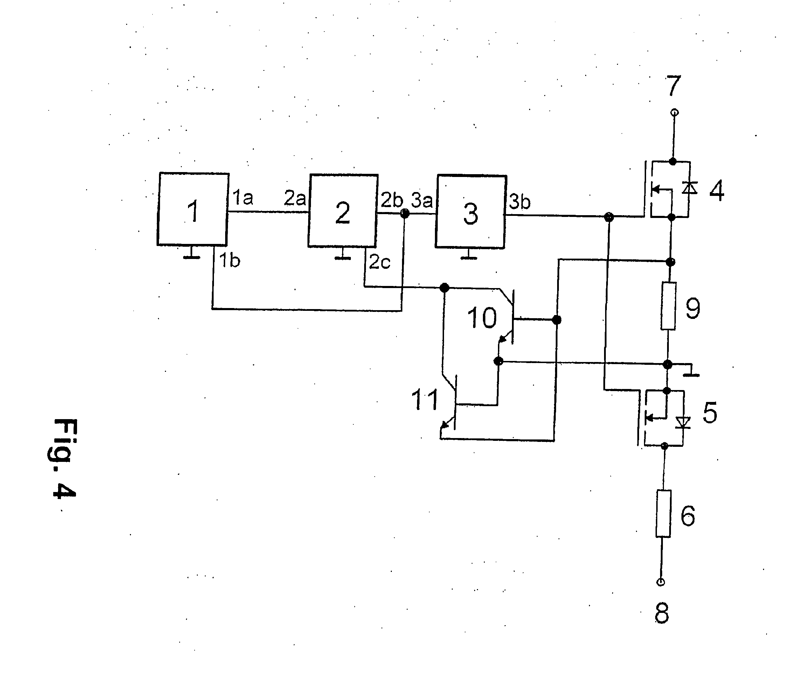

Dieser letztgenannte Nachteil wird bei dem Wechselspannungssteller gemäß dem dritten Ausführungsbeispiel vermieden. Wie in Fig. 4 dargestellt, ist zu diesem Zweck der Ausgang 2b des Zwischenspeichers 2 mit dem Eingang 1b des Signalgebers 1 verbunden. Dadurch kann der Signalgeber 1 einerseits jederzeit den momentanen Einschaltzustand des Gesamtsystems erkennen, andererseits kann er, falls er nicht selbst das Rücksetzen des Zwischenspeichers 2 veranlasst hat, erkennen, dass dies durch einen Überstrom veranlasst wurde.

Die übrigen Merkmale des Wechselspannungsstellers von Fig. 4 entsprechen jenen des zweiten Ausführungsbeispiels von Fig. 3.

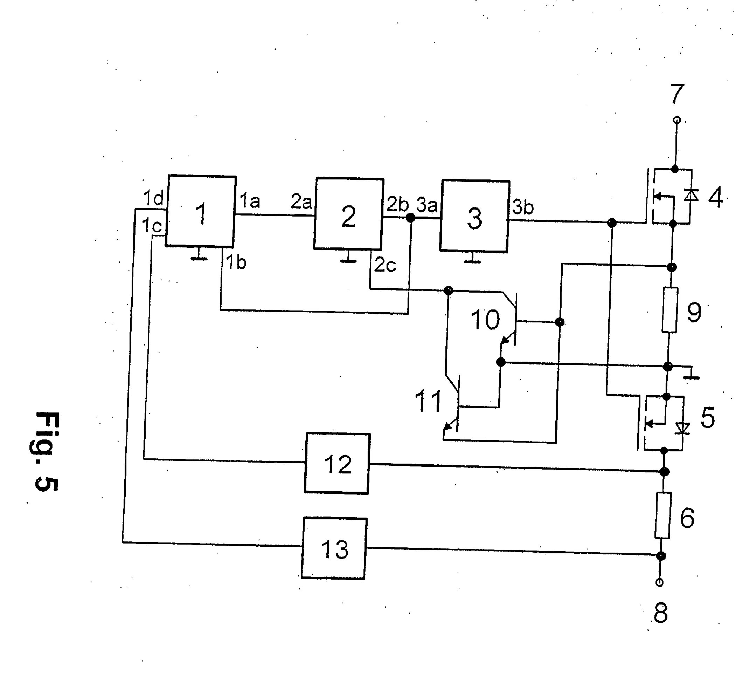

Bezug nehmend auf Fig. 5 wird nun ein viertes Ausführungsbeispiel eines Wechselspannungsstellers näher beschrieben. Gleiche bzw. entsprechende Komponenten sind dabei mit den gleichen Bezugsziffern wie in den obigen Ausführungsbeispielen gekennzeichnet.

Ergänzend zu den oben beschriebenen Ausführungsbeispielen kann es ferner wünschenswert sein, die vom Verbraucher 6 aufgenommene elektrische Leistung und Energie erfassen zu können. Hierzu müssen Strom- und Spannungsverlauf über der Last 6 bestimmt werden.

Problematisch bei der Messung der Spannung über der Last 6 ist, dass das Bezugspotenzial der Ansteuerschaltung 3 der Transistoren 4, 5 zwischen deren Source-Anschlüssen liegt, in diesem Ausführungsbeispiel zwischen dem zweiten Transistor 5 und dem Widerstand 9. Aus Kostengründen wird angestrebt, die Spannung über der Last 6 nach einer Signalaufbereitung (z.B. Filterung) einem Eingang 1d des Signalgebers 1 zuzuführen. Da jedoch zwischen dem Bezugspotenzial des Signalgebers 1 und der Last 6 der zweite Transistor 5 liegt, verfälscht der Spannungsabfall über diesem die Messung. Dies zumal in einer Halbwelle der Transistor 5 je nach Ansteuerzustand leitet, in der anderen seine parasitäre Antiparalleldiode. Zwar ist die Leistung das Produkt aus Strom und Spannung, und im ausgeschalteten Zustand ist der Strom Null, sodass in dieser Zeit der genaue Spannungsverlauf nicht von Interesse ist, und man könnte daher die Spannung nur an dem zweiten Wechselspannungsanschluss 8 messen, jedoch machen sich Spannungsverzerrungen durch die Schaltvorgänge und Spannungsabfälle an der Durchlassstrecke sowie an der Antiparalleldiode bemerkbar und verfälschen das Ergebnis.

Es ist im Stand der Technik bekannt, zur Leistungsmessung entweder einen galvanisch über Strom- und Spannungsübertrager von der Last getrennten Schaltkreis einzusetzen oder die galvanische Trennung an der Schnittstelle zum Signalgeber einzurichten. So kann die reine Spannung über der Last unmittelbar gemessen werden. Die galvanische Trennung ist jedoch kostenintensiv und benötigt viel Platz auf der Leiterplatte.

Gemäß dem vierten Ausführungsbeispiel ist dieses Problem so gelöst, dass an einem ersten Analog-Eingang 1d des Signalgebers 1 der Spannungsverlauf auf der einen Seite der Last 6 [U1 = U(5) + U(6)] und an einem zweiten Analog-Eingang 1 c des Signalgebers 1 der Spannungsverlauf auf der zweiten Seite der Last 6 [U2 = U(5)] relativ zu dem genannten Bezugspotenzial erfasst wird. Im Signalgeber 1 erfolgt dann eine Differenzbildung beider erfassten Signale:

$$U = U1 - U2 = U(5) + U(6) - U(5) = U(6)$$

Auf diese Weise steht der unverfälschte Spannungsverlauf an der Last 6 dem Signalgeber 1 zur Verfügung. Anstelle eines Analogeinganges 1c, 1d kann am Signalgeber 1 auch ein Operationsverstärkereingang oder ein anderer, zur Spannungsbestimmung geeigneter Eingang verwendet werden.

Die auf beiden Seiten der Last 6 abgegriffenen Spannungssignale U1 und U2 werden dem Signalgeber 1 vorzugsweise jeweils über eine Konditionierungsschaltung 12 bzw. 13 zugeführt, wie in Fig. 5 dargestellt. Diese Konditionierungsschaltungen 12, 13 enthalten zum Beispiel einen Schaltkreis mit einem Analogwandler zur Signalaufbereitung (z.B. Filterung).

Die übrigen Merkmale des Wechselspannungsstellers von Fig. 5 entsprechen jenen der obigen Ausführungsbeispiele.

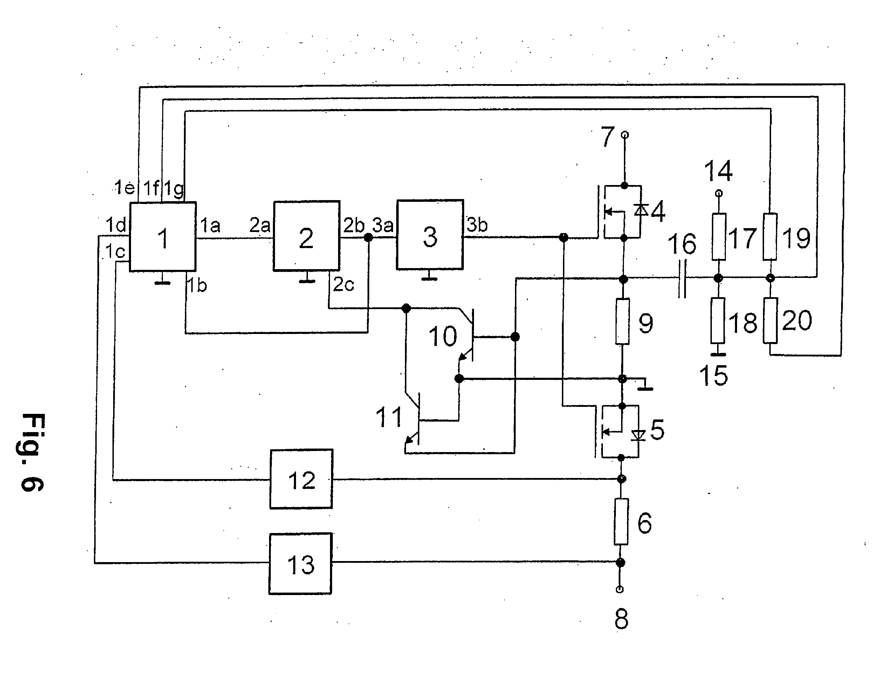

Bezug nehmend auf Fig. 6 wird nun ein fünftes Ausführungsbeispiel eines Wechselspannungsstellers näher beschrieben. Gleiche bzw. entsprechende Komponenten sind dabei mit den gleichen Bezugsziffern wie in den obigen Ausführungsbeispielen gekennzeichnet.

Die Strommessung erfolgt üblicherweise eine Strom-Spannungswandlung. Dies kann grundsätzlich durch einen Übertrager oder durch den Spannungsabfall an einem Widerstand geschehen, welcher vom Laststrom durchströmt wird. Es ist Stand der Technik, hierzu die gleichen Widerstände 9, wie sie für die Strombegrenzung verwendet werden, zu nutzen.

In dem Ausführungsbeispiel von Fig. 6 reicht zur Strommessung ein einziger Widerstand 9 aus. Da der zum Stromverlauf proportionale Spannungsabfall über diesem Widerstand relativ zum Bezugspotenzial der Schaltung in der negativen Netz-Halbwelle bei resistiver Last 6 ebenfalls negativ wird, muss er auf ein relativ zum Bezugspotenzial positives Mittelwertpotenzial, das an einem vorzugsweise analogen Eingang 1f des Signalgebers 1 auswertbar ist, angehoben werden. Hierzu bilden zwei Widerstände 17 und 18 einen Spannungsteiler. Über die Anschlüsse 14 und 15 des Spannungsteilers wird eine Gleichspannung eingespeist, vorzugsweise die Versorgungsspannung der Schaltung selbst.

Am Mittelpunkt der Wechselspannungsschaltstufe wird über einen Kondensator 16 der dem Wechselstrom proportionale Wechselspannungsanteil eingespeist. Ein Mikrocontroller 1, der das Signal am Eingang 1f auswertet, weiß, dass der Gleichspannungs-Offset dem Stromwert Null entspricht, eine Spannung darüber einem Strom in positiver Richtung, eine Spannung darunter einem Strom in negativer Richtung.

Asymmetrische Lasten 6, welche positive und negative Halbwelle ungleich belasten, können auf diese Weise nicht genau erfasst werden. Dies ist bei den meisten Applikationen, die in Betracht kommen, nicht von Relevanz.

Es kann bei oben genannter Schaltungsanordnung passieren, dass ein nachgeschalteter Vorverstärker, welcher im Signalgeber 1 integriert ist, den Gleichspannungspegel an seinem Eingang 1f mitverstärkt. Möchte man das Eingangssignal einerseits abschwächen, um eine größere Bereichsspreizung des interessierenden Wechselspannungssignals bei reduzierter Auflösung zu erhalten, oder andererseits höher verstärken, um bei reduziertem Bereich eine genauere Signalauflösung zu erhalten, verschiebt sich auch der Gleichspannungspegel und bringt schlechtestenfalls den Verstärkerausgang in Sättigung.

Wie in Fig. 6 dargestellt, kann dies vermieden werden, indem der Gleichspannungs-Offset vom messenden Signalgeber 1 auf den jeweils zur Auswertung günstigsten Wert verändert werden kann. Eine kostengünstige Lösung besteht darin, das Teilerverhältnis des Spannungsteilers 17, 18 zu verschieben, indem entweder dem einen Widerstand 18 ein weiterer Widerstand 20 gegen Masse parallel geschaltet wird, oder dem anderen Widerstand 17 ein weiterer Widerstand 19 gegen die positive Betriebsspannung.

Um einen externen Schalter zu sparen, dient der Prozessorausgang 1e oder 1g des Signalgebers 1 gleichzeitig als 3-Wege-Schalter, indem er entweder hochohmig geschaltet wird (entsprechend einem offenen Schalter) oder als Ausgang geschaltet auf sein Bezugspotenzial logisch "0" gezogen wird (entsprechend einem Schalter gegen Masse) oder als Ausgang geschaltet auf positive Betriebsspannung logisch "1" geschaltet wird. Es können so beliebig viele Widerstände einzeln oder parallel geschaltet den Spannungs-Offset in gewünschter Weise verschieben. Wichtig ist, dass die Teilerwiderstände sehr hochohmig im Verhältnis zum Messwiderstand 9 und zur Impedanz des Koppelkondensators 16 gehalten werden.

Die vorgeschlagene Auswerteschaltung besitzt verschiedene toleranzbehaftete Widerstände, zum Beispiel auch die oben beschriebenen Spannungsteiler. Um deren Kosten gering zu halten, also Widerstände mit hoher Toleranz verwenden zu können, wird erfindungsgemäß vorgeschlagen, den Gleichspannungs-Offset, welcher sich jeweils für verschiedene Teilerverhältnisse ergibt, im Signalgeber 1 zu erfassen und als Bezugspotenzial zwischenzuspeichern. Dies geschieht dann, wenn bekannterweise kein Transistor 4, 5 angesteuert ist, also kein Strom durch den Widerstand 9 fließt. Werte oberhalb des Bezugspotenzials entsprechen positivem Strom, Werte darunter negativem Strom, und es wird nur die jeweilige Differenz zum Wert des Gleichspannungs-Offsets ausgewertet. Der Absolutwert des Offsets wird damit eliminiert und sein mit der Widerstandstoleranz verbundener Fehler fällt aus der Rechnung heraus.

Messwiderstände (Toleranzen von 0,1%, 0,5%, 1%) sind im Verhältnis zu solchen mit normaler Toleranz (z.B. 5%) sehr teuer. Die Toleranz des Messwiderstandes 9 kann erfindungsgemäß durch eine Kalibrationsmessung eliminiert werden, indem ein bekannter Strom in den Messwiderstand 9 eingeprägt und vom Signalgeber 1 gemessen wird. Das toleranzbehaftete Messergebnis wird in Bezug zum erwarteten Sollwert gesetzt und ein Wert, der dieses Verhältnis repräsentiert oder ihm proportional ist, in einem nichtflüchtigen Speicher abgelegt. Bei späteren Messungen beliebiger Signale wird der Messwert mit dem abgespeicherten Korrekturwert beaufschlagt und so das genaue Ergebnis errechnet. Die Kalibrierung geschieht z.B. in der Fertigung des Herstellers.

Die übrigen Merkmale des Wechselspannungsstellers von Fig. 6 entsprechen jenen des vierten Ausführungsbeispiels von Fig. 5.

BEZUGSZIFFERNLISTE

1   Signalgeber

2   Zwischenspeicher

3   Ansteuerschaltung

4   erster Transistor

5   zweiter Transistor

6   Last

7   erster Wechselspannungsanschluss

8   zweiter Wechselspannungsanschluss

9   Widerstand

10   erstes Schaltelement

11   zweites Schaltelement

12      erste Konditionierungsschaltung

13      zweite Konditionierungsschaltung

14      erster Gleichspannungsanschluss

15      zweiter Gleichspannungsanschluss

16      Kondensator

17      erster Widerstand des Spannungsteilers

18      zweiter Widerstand des Spannungsteilers

19      Widerstand

20      Widerstand

**Patentansprüche**

1.  Wechselspannungssteller, mit
    zwei Transistoren (4, 5), die zwischen zwei Wechselspannungsanschlüssen (7, 8) in Reihe zu einer Last (6) setzbar sind, wobei die zwei Transistoren (4, 5) derart in Reihe geschaltet sind, dass ihre jeweiligen Source-Anschlüsse miteinander verbunden sind;
    einem Signalgeber (1) zum Erzeugen eines Schaltsignals zum Ansteuern der beiden Transistoren (4, 5);
    einem dem Signalgeber (1) nachgeschalteten Zwischenspeicher (2), welcher von dem Signalgeber (1) gesetzt wird, um die beiden Transistoren (4, 5) anzusteuern;
    einer Ansteuer- oder Treiberschaltung (3), welche dem Zwischenspeicher (2) nachgeschaltet ist, zum Ansteuern der beiden Transistoren (4,5) entsprechend dem gesetzten Zustand des Zwischenspeichers (2); und einer Strombegrenzungsschaltung (9-11) zum Begrenzen oder Abschalten des Stroms durch die zwei Transistoren (4, 5) im Fall eines zu großen Stroms durch die Last (6).

2.  Wechselspannungssteller nach Anspruch 1,
    **dadurch gekennzeichnet, dass**
    die Strombegrenzungsschaltung (9-11) ein erstes Schaltelement (10) und ein zweites Schaltelement (11) sowie wenigstens einen in Reihe zu den zwei Transistoren (4, 5) geschalteten Widerstand (9) aufweist;
    ein Spannungsabfall an dem wenigstens einen Widerstand (9) in der einen Stromrichtung durch den Verbraucher (6) das erste Schaltelement (10) durchschaltet und ein Spannungsabfall an dem wenigstens einen Widerstand (9) in der anderen Stromrichtung durch den Verbraucher (6) das zweite Schaltelement (10) durchschaltet; und
    das erste oder das zweite Schaltelement (10, 11) bei einem Durchschalten den Signalgeber (1) und/oder den Zwischenspeicher (2) derart ansteuert, dass die beiden Transistoren (4, 5) ausgeschaltet werden wobei ein Durchschalten des ersten und/oder des zweiten Schaltelements (10, 11) ein Zurücksetzen des Zwischenspeichers (2) und/oder ein Triggern des Signalgebers (1), um ein erneutes Setzen des Zwischenspeichers (2) zu verhindern, bewirkt.

3.  Wechselspannungssteller nach Anspruch 1 oder 2,
    **dadurch gekennzeichnet, dass**
    ein Ausgang (2b) des Zwischenspeichers (2) mit einem Eingang (1 b) des Signalgebers (1) verbunden ist.

4.  Wechselspannungssteller nach einem der vorhergehenden Ansprüche,
    **dadurch gekennzeichnet, dass**
    der Signalgeber (1) zum Erfassen eines Spannungsabfalls über der Last (6) ausgebildet ist.

5.  Wechselspannungssteller nach Anspruch 4,
    **dadurch gekennzeichnet, dass**
    ein erster Eingang (1c) des Signalgebers (1) mit einem ersten Anschluss der Last (6) verbunden ist und ein zweiter Eingang (1d) des Signalgebers (1) mit einem zweiten Anschluss der Last (6) verbunden ist, um die Spannungsverläufe an den beiden Anschlüssen der Last (6) zu erfassen.

6. Wechselspannungssteller nach einem der vorhergehenden Ansprüche,
**dadurch gekennzeichnet, dass**
der Signalgeber (1) zum Erfassen eines Stromverlaufs durch die Last (6) ausgebildet ist.

7. Wechselspannungssteller nach Anspruch 6,
**dadurch gekennzeichnet, dass**
zum Erfassen eines Stromverlaufs durch die Last (6) ein Kondensator (16) vorgesehen ist, welcher einen dem Wechselstromanteil über den wenigstens einen Widerstand (9) proportionalen Wechselspannungsabfall auskoppelt und einem Eingang (1f) des Signalgebers (1) zuführt.

8. Wechselspannungssteller nach Anspruch 7,
**dadurch gekennzeichnet, dass**
der Kondensator (16) den dem Wechselstromanteil über den wenigstens einen Widerstand (9) proportionalen Wechselspannungsabfall auf einen Spannungsteiler (17, 18) auskoppelt.

9. Wechselspannungssteller nach Anspruch 8,
**dadurch gekennzeichnet, dass**
der Signalgeber (1) derart ausgebildet ist, um ein Verhältnis des Spannungsteilers (17, 18) einzustellen.

10. Wechselspannungssteller nach einem der Ansprüche 6 bis 9,
**dadurch gekennzeichnet, dass**
der Signalgeber (1) ausgebildet ist, um einen Referenzstrom bei ausgeschalteter Last (6) oder bei bekanntem Strom zu erfassen und diesen Referenzstrom bei der Erfassung des Stromverlaufs durch die Last (6) zu berücksichtigen.

11. Wechselspannungssteller nach einem der vorhergehenden Ansprüche,
**dadurch gekennzeichnet, dass**
der Signalgeber (1) derart ausgebildet ist, dass er beim Einschalten einer nichtlinearen Last (6) ein Ansprechen einer Strombegrenzung für eine vorbestimmte Zeitdauer ignoriert.

12. Wechselspannungssteller nach einem der vorhergehenden Ansprüche,
**dadurch gekennzeichnet, dass**
der Signalgeber (1) mit einem Speicher versehen ist, in welchem ein ein-oder mehrmals ermitteltes Einschaltverhalten der Last (6) abgelegt werden kann.

Fig. 1

Fig. 2

Fig. 3

Fig. 4

Fig. 5

Fig. 6